# FASCICULE DE BREVET EUROPEEN

(11) **EP 1 522 533 B1**
(45) Date de publication et mention de la délivrance du brevet: **14.04.2010**
(21) Numéro de dépôt: 04292267.4
(22) Date de dépôt: 22.09.2004
(51) Int. Cl.: C04B 35/486, C23C 14/08

(54) **Cible destinée à être évaporée sous faisceau d'électrons et son procédé de fabrication.**
Target für Elektronstrahlverdampfung und Verfahren zur dessen Herstellung.
Target destined for electron beam evaporation and its process of manufacture.

(30) Priorité: 09.10.2003 FR 0311812
(43) Date de publication de la demande: 13.04.2005
(73) Titulaire: SNECMA, 75015 Paris (FR)
(72) Inventeur: Saint-Ramond, Bertrand, 77300 Fontainebleau (FR); Malie, André, 86100 Chatellerault (FR); Chaput, Christophe, 87140 Le Palais sur Vienne (FR); Porte, Isabelle, 87920 Condat-sur-Vienne (FR); Delage, Cyrille, 87410 Le Palais sur Vienne (FR)
(74) Mandataire: Cardy, Sophie Marie

(56) Documents cités:
- EP-A- 0 812 931
- EP-A- 0 931 852
- EP-A- 0 987 345
- EP-A- 1 055 743
- EP-A- 1 357 201
- DE-C- 4 302 167

## Description

L'invention concerne une cible composite en forme de barreau, formée de poudres céramiques et destinée à être évaporée sous faisceau d'électrons, comportant de la zircone et au moins un stabilisant de la zircone, ainsi que son procédé de fabrication.

La recherche de l'augmentation du rendement des turbomachines, en particulier dans le domaine aéronautique, et de la diminution de la consommation en carburant et des émissions polluantes de gaz et d'imbrûlés ont conduit à se rapprocher de la stoéchiométrie de combustion du carburant. Cette situation s'accompagne d'une augmentation de la température des gaz sortant de la chambre de combustion en direction de la turbine.

En conséquence, il a fallu adapter les matériaux de la turbine à cette élévation de température, en perfectionnant les techniques de refroidissement des aubes de turbines (aubes creuses) et/ou en améliorant les propriétés de résistance aux températures élevées de ces matériaux. Cette deuxième voie, en combinaison avec l'utilisation des superalliages à base de nickel et/ou de cobalt, a conduit à plusieurs solutions parmi lesquelles le dépôt d'un revêtement isolant thermique dénommé barrière thermique.

Ce revêtement de céramique permet de créer sur une pièce refroidie, en régime permanent de fonctionnement, un gradient thermique au travers du revêtement, dont l'amplitude totale peut dépasser 200°C pour un revêtement de 150 µm d'épaisseur environ. La température de fonctionnement du métal sous-jacent formant le substrat pour le revêtement se trouve diminuée du même gradient, ce qui induit des gains importants sur le volume d'air de refroidissement nécessaire, la durée de vie de la pièce et la consommation spécifique du moteur à turbine.

Il est bien entendu qu'il peut être prévu, afin d'améliorer les propriétés de la barrière thermique, notamment de liaison avec le substrat, d'ajouter, entre le substrat et le revêtement, une sous-couche. En particulier, il est connu d'utiliser une sous-couche formée d'un ou de plusieurs aluminiures, comprenant en particulier un aluminiure de nickel contenant éventuellement un métal choisi parmi le platine, le chrome, le palladium, le ruthénium, l'iridium, l'osmium, le rhodium, ou un mélange de ces métaux et/ou un élément réactif choisi parmi le zirconium (Zr), le hafnium (Hf) et l'yttrium (Y), et/ou d'un alliage de type McrAlY, M étant un métal choisi parmi le nickel, le cobalt, le fer ou un mélange de ces métaux.

Habituellement, les revêtements de céramique sont déposés sur la pièce à revêtir soit par une technique de projection (en particulier projection plasma) ou de dépôt par voie physique en phase vapeur, c'est-à-dire par évaporation (en particulier par EB-PVD ou « Electron Beam Physical Vapour Deposition » formant un revêtement déposé dans une enceinte d'évaporation sous vide sous bombardement électronique).

Dans le cas d'un revêtement projeté, un dépôt d'oxyde à base de zircone est effectué par des techniques du type projection plasma, ce qui conduit à la formation d'un revêtement constitué d'un empilement de gouttelettes fondues puis trempées par choc, aplaties et empilées de façon à former un dépôt densifié de manière imparfaite d'une épaisseur généralement comprise entre 50 micromètres et 1 millimètre.

Un revêtement déposé par voie physique, et en particulier par évaporation sous bombardement électronique, engendre un revêtement constitué d'un assemblage de colonnettes dirigées sensiblement de manière perpendiculaire à la surface à revêtir, sur une épaisseur comprise entre 20 et 600 micromètres. Avantageusement, l'espace entre les colonnettes permet au revêtement de compenser efficacement les sollicitations thermomécaniques dues, aux températures de service, au différentiel de dilatation avec le substrat en superalliage et aux contraintes mécaniques centrifuges de rotation des aubes. Ainsi, on obtient des pièces avec des durées de vie élevées en fatigue thermique à haute température.

Classiquement, ces barrières thermiques créent donc une discontinuité de conductivité thermique entre le revêtement extérieur de la pièce mécanique, comprenant cette barrière thermique, et le substrat de ce revêtement formant le matériau constitutif de la pièce.

De manière habituelle, on constate que les barrières thermiques qui engendrent une discontinuité importante de conductivité thermique sont en contrepartie génératrices d'un risque de délaminage important entre le revêtement et le substrat, ou plus précisément à l'interface entre la sous-couche et la barrière thermique en céramique.

Actuellement, on cherche à obtenir des compositions de barrières thermiques qui permettent une résistance des pièces mécaniques jusqu'à une température d'environ 1500°C en surface, soit environ jusqu'à 1300°C dans le substrat. Les barrières thermiques actuellement utilisées permettent une résistance des pièces mécaniques jusqu'à une température d'environ 1200-1300°C en surface, soit 1000-1100°C dans le substrat.

Il est connu de recourir à l'utilisation d'une barrière thermique obtenue à partir du matériau de base constitué de zircone qui présente un coefficient de dilatation proche du superalliage constituant le substrat et une conductivité thermique assez faible.

C'est le type de revêtement obtenu par évaporation d'une cible sous faisceau d'électrons qui est concerné par la présente invention. Les cibles utilisées subissent un choc thermique lorsqu'elles sont irradiées par le faisceau d'électrons, ce choc thermique pouvant conduire à la rupture de la cible, en particulier si cette dernière présente des défauts et/ou des irrégularités. Lorsqu'il y a rupture de la cible, celle-ci n'est en pratique plus utilisable car elle ne permet plus de fournir régulièrement en matériau par évaporation.

La demande de brevet EP1055743 porte sur un matériau pouvant être déposé par évaporation sous faisceau d'électrons dans lequel on cherche à compenser, au moins en partie, le changement de volume du matériau dû à la dilatation thermique engendrée lors de l'élévation de température induite par l'irradiation, par la diminution de volume de 4% induite par la transition de phase entre la zircone monoclinique qui se transforme en zircone tétragonale lors d'une élévation de température entre 500 et 1200°C. Plus précisément, on joue sur une répartition large de la taille des particules de la poudre de structure monoclinique pour que cette compensation intervienne sur une plage de valeurs de température assez large.

EP1055743 prévoit également la présence de zircone monoclinique, à hauteur de 25 à 90%, ou de préférence entre 40 à 85%, pour améliorer les performances de résistance au choc thermique. Cette résistance améliorée provient, comme dans DE 4 302 167, de l'apparition, lors de la transition de phase entre la phase tétragonale et la phase monoclinique lors de la chute de température, de micro-fissures qui sont capables d'absorber l'énergie du choc thermique de façon à empêcher la propagation de fissures, et donc la rupture du matériau. Selon, EP1055743, le double rôle précité de la zircone monoclinique permet d'augmenter la résistance aux chocs thermiques.

Selon EP1055743, en dehors de ces plages de valeurs, les cibles ne sont pas exploitables. Plus précisément, pour un taux de phase monoclinique de la zircone inférieur à 25%, l'expansion thermique pendant l'évaporation est moins compensée par la diminution de volume lors de la transformation de phase, et la proportion de microfissures est trop faible, ce qui limite la résistance aux chocs thermiques. Pour un taux de phase monoclinique de la zircone supérieur à 90%, l'expansion de volume, induite par la transition de phase entre la zircone tétragonale qui se transforme en zircone monoclinique lors du refroidissement qui suit l'élévation de température inhérente à l'évaporation, est trop importante, ce qui entraîne des fissures (criques ou tapures) diminuant fortement la résistance mécanique de la cible et pouvant remettre en cause son intégrité physique.

La présente invention a pour objectif de fournir une solution permettant l'obtention d'une cible composite en forme de barreau, constituée d'un ou de plusieurs mélanges de poudres céramiques, comportant de la zircone et au moins un stabilisant de la zircone, et destinée à être évaporée sous faisceau d'électrons, qui puisse être aisément mise en oeuvre de manière reproductible en donnant lieu à une cible de bonne qualité.

La présente invention a donc pour objectif de permettre l'obtention d'une cible en céramique destinée à être évaporée sous faisceau d'électrons pour l'obtention d'une couche en céramique déposée ayant la même composition que celle de la cible.

A cet effet, selon la présente invention, il est proposé une cible conforme à la revendication 1.

En fait, contrairement à l'enseignement de EP1055743, il a été constaté, de manière surprenante qu'un taux de plus de 90% de zircone monoclinique est tout à fait compatible avec les propriétés recherchées de résistance mécanique à froid et en choc thermique des cibles.

Grâce à l'invention, il est possible d'obtenir en effet, des cibles avec des propriétés mécaniques optimales pour cette application, à savoir une résistance mécanique assez faible pour permettre à la fois une bonne résistance aux chocs thermiques et une résistance mécanique suffisante pour pouvoir manipuler les cibles sans les détériorer.

Il a été constaté que le comportement à l'évaporation des cibles présentant un taux de phase monoclinique de zircone supérieur à 90% est moins sensible aux variations des autres caractéristiques des cibles, notamment le diamètre des pores, la densité et le taux de porosité.

En effet, par exemple, il a été observé que des variations de diamètres des pores de 0,4 à 1,5 µm à densité constante, ou des variations de densités de 2,8 à 3,3 à diamètre de pores constant, conduisent à des résultats identiques que ce soit au niveau du comportement lors des dépôts par évaporation ou des caractéristiques des revêtements obtenus lors de ces dépôts.

Ces variations précitées des caractéristiques des cibles peuvent être induites par des changements de lots de poudres, et donc de diamètre moyen et de surface spécifique des particules de la poudre. En effet, d'un lot à l'autre de poudre, de faibles écarts de taille de particules ou de surface spécifique sont couramment observés.

Ainsi, grâce à ce choix de prévoir un taux de phase monoclinique de zircone supérieur à 90% dans la cible, on peut mettre en oeuvre le même procédé de fabrication des cibles, sans modification des paramètres de fabrication, malgré les écarts de caractéristiques des poudres utilisées.

De préférence, dans la cible, ladite zircone est formée à plus de 98% d'une phase monoclinique.

Selon une disposition préférentielle, ledit stabilisant comprend au moins un élément appartenant au groupe formé des oxydes de terres rares, de l'oxyde de tantale et de l'oxyde de niobium. A cet égard, on entend par terres rares les lanthanides (lanthane, cérium, praséodyme, néodyme, prométhium, samarium, europium, gadolinium, terbium, dysprosium, holmium, erbium, thulium, ytterbium et lutétium) et le scandium et l'yttrium.

De préférence, la cible présente une densité inférieure à 3,9, de préférence comprise entre 2,5 et 3,3.

Egalement, de préférence, la cible présente un diamètre moyen de pores d₅₀ compris entre 0,2 et 1,5 µm et plus particulièrement entre 0,4 et 1,2 µm).

Les deux paramètres que constituent le diamètre moyen des pores et la densité des cibles, influencent la tenue mécanique des cibles, et leur comportement lors des évaporations, notamment la résistance aux chocs thermiques. Ces facteurs peuvent être contrôlés par le choix des matières premières initiales et par les paramètres de fabrication.

La présente invention porte également sur une cible qui présente une composition variable en hauteur.

La présente invention propose également un procédé de fabrication d'une cible composite en forme de barreau selon l'une quelconque des revendications précédentes, formée de poudres céramiques et destinée à être évaporée sous faisceau d'électrons. Selon l'invention, ce procédé est caractérisé en ce qu'il comprend les étapes suivantes :
a) préparation d'au moins un premier mélange ayant une première composition à partir d'un liant et de poudres comportant de la zircone et au moins un stabilisant de la zircone, ladite zircone étant formée à plus de 90%, et de préférence de l'ordre de 100%, d'une phase monoclinique ;
b) introduction dudit mélange dans un moule ;
c) compactage du mélange dans ledit moule ;
d) cuisson du mélange compacté à une température inférieure à la température de stabilisation du mélange considéré.

Cette température de stabilisation est fonction du système de poudres considéré : elle est en général inférieure à 1500 °C, de préférence comprise entre 900 et 1100 °C.

Cette température de cuisson doit être suffisamment faible pour conserver un taux de phase monoclinique supérieur à 90% dans la cible, c'est-à-dire limiter la stabilisation de la zircone qui s'accompagne de la création de ponts entre les particules de la poudre, et provoque une chute de résistance aux chocs thermiques.

L'utilisation de poudre de zircone pure, c'est-à-dire non stabilisée, lors de l'étape a), permet de fabriquer des cibles de composition très variées à un coût moindre. En effet, dans le commerce, sont couramment vendues des zircones stabilisées avec les stabilisants les plus conventionnels constitués par Y₂O₃, MgO, CaO, et CeO₂ avec des taux fixes (en particulier un taux de 3, 4 ou 5 % molaire pour Y₂O₃ par rapport à la quantité de ZrO₂ ). La synthèse de poudres stabilisées avec d'autres types de stabilisants (oxydes de terres rares par exemple) ou avec des taux particuliers est onéreuse : elle se fait soit par voie chimique (précurseurs onéreux), soit par voie physique (calcination d'un mélange, puis broyage et tamisage pour obtenir la granulométrie souhaitée). De plus, l'utilisation d'un (ou de plusieurs) mélange(s) de poudres brutes permet de contrôler la composition chimique dans toutes les sections s'étendant selon la longueur de la cible, ce qui permet de faire varier le taux d'un composé dans l'épaisseur du revêtement, selon les besoins. Ce procédé évite donc la synthèse à l'avance d'une multitude de mélanges de zircones stabilisées dans le cas de réalisation de cibles composites formées de plusieurs tronçons de compositions différentes.

Le liant est de préférence à base aqueuse en comportant de l'eau, mais il peut aussi comporter un liant organique tel que l'alcool polyvinylique.

Selon une disposition préférentielle, ledit stabilisant comprend au moins un élément appartenant au groupe formé des oxydes de terres rares, de l'oxyde de tantale et de l'oxyde de niobium. A cet égard, on entend par terres rares les lanthanides (lanthane, cérium, praséodyme, néodyme, prométhium, samarium, europium, gadolinium, terbium, dysprosium, holmium, erbium, thulium, ytterbium et lutétium) et le scandium et l'yttrium.

De préférence, ladite étape a) comporte la préparation d'au moins un deuxième mélange ayant une deuxième composition à partir d'un liant et de poudres comportant de la zircone et au moins un stabilisant de la zircone, ladite zircone étant formée à plus de 90% d'une phase monoclinique et en ce que l'étape b) comporte l'introduction successive du premier mélange et du deuxième mélange, ce par quoi on obtient une cible ayant une composition variable en hauteur.

De préférence, lesdites poudres céramiques présentent un diamètre moyen de particules compris entre 5 et 30 µm, ou bien une surface spécifique inférieure à 10 m²/g, de préférence une surface spécifique comprise entre 3 et 8 m²/g.

Selon une autre disposition, lesdites poudres céramiques présentent un diamètre moyen de particules inférieur à 5 µm et en ce que l'étape a) comprend une sous-étape de calcination de la poudre avant l'incorporation du liant.

Une telle étape de calcination permet de réajuster la taille des grains de poudre à une valeur comprise entre 5 et 30 µm.

Il est possible de poser une barrière thermique de faible conductivité thermique et de forte résistance thermomécanique en céramique formée par évaporation sous faisceau d'électrons d'une cible selon l'invention sur un substrat en superalliage.

Il est ainsi possible d'obtenir un revêtement de céramique comportant une sous-couche de liaison, une première couche de céramique à base de zircone yttriée comprenant une teneur molaire d'oxyde d'yttrium entre 4 et 12% et une deuxième couche de céramique formée d'une barrière thermique selon le paragraphe qui précède, ladite première couche de céramique étant située entre ladite sous-couche de liaison et ladite deuxième couche de céramique.

Enfin, on peut réaliser une pièce mécanique en superalliage, qui comporte un revêtement de céramique comprenant une barrière thermique obtenue à partir d'une cible selon l'invention.

En particulier, les dispositions préférentielles suivantes sont mises en oeuvre en relation avec la pièce mécanique :
- elle comporte en outre une sous-couche de liaison sur laquelle est déposé ledit revêtement de céramique ;
- ladite sous-couche de liaison est constituée d'un alliage apte à former une couche d'alumine protectrice par oxydation ;
- ladite sous-couche de liaison est constituée d'un alliage de type MCrAIY, M étant un métal choisi parmi le nickel, le cobalt, le fer ou un mélange de ces métaux ;
- ladite sous-couche de liaison est constituée d'un aluminiure de nickel contenant éventuellement un métal choisi parmi le platine, le chrome, le palladium, le ruthénium, l'iridium, l'osmium, le rhodium, ou un mélange de ces métaux et/ou un élément réactif choisi parmi le zirconium (Zr), le hafnium (Hf) et l'yttrium (Y) ; et/ou
- ledit revêtement de céramique comporte en outre, sur ladite sous-couche, une couche de céramique à base de zircone yttriée comprenant une teneur molaire d'oxyde d'yttrium entre 4 et 12%.

D'autres avantages et caractéristiques de l'invention ressortiront à la lecture de la description suivante d'exemples de réalisation de cibles cités de manière non limitative.

### EXEMPLE 1 (comparatif)

La cible a été préparée dans les conditions suivantes :
- mélange de poudre de ZrO₂ (100% monoclinique, un diamètre moyen des particules d₅₀=25 µm et une surface spécifique de 1,20 m²/g) et de poudre de Y₂O₃ (4% molaire par rapport à la quantité de ZrO₂, diamètre moyen des particules d₅₀=5,16 µm), ces poudres ayant une pureté >99,9%,
- addition d'un liant sous forme d'alcool polyvinylique à hauteur de 3,5% en masse de l'ensemble du mélange,
- introduction de ce mélange dans un moule,
- mise sous pression à 100 bars (pressage isostatique)
- cuisson à 1300°C pendant 1 heure

La cible ainsi obtenue présente une densité de 3,27, un diamètre moyen de pores d₅₀=2,04 µm, une porosité de 44%, un taux de phase cristalline monoclinique de 91,7%, une expansion thermique de 6,8 10⁻² et un retrait global de volume de 3,7%.

Aucun dépôt n'a toutefois pu être réalisé car le barreau formant la cible s'est fissuré après le préchauffage à 850°C.

### EXEMPLE 2 :

La cible a été préparée dans les conditions suivantes :
- mélange de poudre de ZrO₂ (100% monoclinique, un diamètre moyen des particules d₅₀=16,7 µm et une surface spécifique de 4,4 m²/g) et de poudre de Y₂O₃ (4% molaire par rapport à la quantité de ZrO₂, diamètre moyen des particules d₅₀=0,99 µm), ces poudres ayant une pureté >99,9% ,
- addition d'un liant sous forme d'alcool polyvinylique à hauteur de 3,0% en masse de l'ensemble du mélange,
- introduction de ce mélange dans un moule,
- mise sous pression à 1600 bars (pressage isostatique)
- cuisson à 1000°C pendant 1 heure

La cible ainsi obtenue présente une densité de 3,11, un diamètre moyen de pores d₅₀=0,75 µm, une porosité de 44%, un taux de phase cristalline monoclinique de 100%, une expansion thermique de 0,78 10⁻² et un retrait global de volume de 7,4%.

Un dépôt été réalisé avec succès avec ce barreau en créant un revêtement de céramique formant une barrière thermique.

### EXEMPLE 3 :

La cible a été préparée dans les conditions suivantes :
- mélange de poudre de ZrO₂ (100% monoclinique, un diamètre moyen des particules d₅₀=21,8 µm et une surface spécifique de 7,7 m²/g) et de poudre de Dy₂O₃ (12% molaire par rapport à la quantité de ZrO₂, diamètre moyen des particules d₅₀=2,97 µm), ces poudres ayant une pureté >99,9%,
- addition d'un liant sous forme d'alcool polyvinylique à hauteur de 4,0% en masse de l'ensemble du mélange,
- introduction de ce mélange dans un moule,
- mise sous pression à 1600 bars (pressage isostatique)
- cuisson à 1000°C pendant 1 heure

La cible ainsi obtenue présente une densité de 3,14, un diamètre moyen de pores d₅₀=0,40 µm, une porosité de 49%, un taux de phase cristalline monoclinique de 95%, une expansion thermique de 0,55 10⁻² et un retrait global de volume de 9,5%.

Un dépôt été réalisé avec succès avec ce barreau en créant un revêtement de céramique formant une barrière thermique.

## Revendications

1. Cible composite en forme de barreau, formée de poudres céramiques et destinée à être évaporée sous faisceau d'électrons, comportant de la zircone et au moins un stabilisant de la zircone, **caractérisée en ce que** ledit stabilisant de la zircone est compris avec une teneur molaire comprise entre 2 et 30%, **en ce que** ladite zircone est formée, après frittage, à plus de 90% d'une phase monoclinique, **en ce qu'**elle présente un diamètre moyen de portes d₅₀ inféneure à 2µm et **en ce qu'**elle présente une porosité de 30 à 50%.

2. Cible selon la revendication 1, **caractérisée en ce que** le stabilisant comprend au moins un élément appartenant au groupe formé des oxydes de terres rares, de l'oxyde de tantale et de l'oxyde de niobium.

3. Cible selon l'une quelconque des revendications précédentes, **caractérisée en ce qu'**elle présente une densité inférieure à 3,9.

4. Cible selon l'une quelconque des revendications précédentes, **caractérisée en ce qu'**elle présente une composition variable en hauteur.

5. Procédé de fabrication d'une cible composite en forme de barreau selon l'une quelconque des revendications précédentes, formée de poudres céramiques et destinée à être évaporée sous faisceau d'électrons, **caractérisé en ce qu'**il comprend les étapes suivantes :
a) préparation d'au moins un premier mélange ayant une première composition à partir d'un liant et de poudres comportant de la zircone et au moins un stabilisant de la zircone, ladite zircone étant formée à plus de 90% d'une phase monoclinique ;
b) introduction dudit mélange dans un moule ;
c) compactage du mélange dans ledit moule ;
d) cuisson du mélange compacté à une température inférieure à 1500°C.

6. Procédé de fabrication selon la revendication 5, **caractérisé en ce que** le stabilisant comprend au moins un élément appartenant au groupe formé des oxydes de terres rares, de l'oxyde de tantale et de l'oxyde de niobium.

7. Procédé de fabrication selon la revendication 5 ou 6, **caractérisé en ce que** l'étape a) comporte la préparation d'au moins un deuxième mélange ayant une deuxième composition à partir d'un liant et de poudres comportant de la zircone et au moins un stabilisant de la zircone, ladite zircone étant formée à plus de 90% d'une phase monoclinique et **en ce que** l'étape b) comporte l'introduction successive du premier mélange et du deuxième mélange, ce par quoi on obtient une cible ayant une composition variable en hauteur.

8. Procédé de fabrication selon l'une quelconque des revendications 5 à 7, **caractérisé en ce que** lesdites poudres céramiques présente un diamètre moyen de particules compris entre 5 et 30µm.

9. Procédé de fabrication selon l'une quelconque des revendications 5 à 7, **caractérisée en ce que** lesdites poudres céramiques présentent un diamètre moyen de particules inférieur à 5 µm et **en ce que** l'étape a) comprend une sous-étape de calcination de la poudre avant l'incorporation du liant.

## Claims

1. A composite target in the form of a bar made of ceramic powders for the purpose of being evaporated under an electron beam, the target comprising zirconia and at least one zirconia stabilizer, the target being **characterized in that** said zirconia stabilizer is included at a molar content lying in the range 2% to 30%, **in that** said zirconia is formed, after sintering, by more than 90% of a monoclinic phase, **in that** said target presents mean pore diameter d₅₀ less than 2 µm and **in that** said target presents porosity of 30% to 50%.

2. A target according to claim 1, **characterized in that** the stabilizer comprises at least one element belonging to the group formed by rare earth oxides, tantalum oxide, and niobium oxide.

3. A target according to any preceding claim, **characterized in that** it presents specific gravity of less than 3.9.

4. A target according to any preceding claim, **characterized in that** it presents a composition that varies along its height.

5. A method of fabricating a composite target in the form of a bar according to any preceding claim, the target being made of ceramic powders and being intended for being evaporated under an electron beam, the method being **characterized it that** comprises the following steps:
a) preparing at least a first mixture having a first composition from a binder and powders comprising zirconia and at least one zirconia stabilizer, said zirconia being formed by more than 90% of a monoclinic phase;
b) introducing said mixture into a mold;
c) compacting the mixture in said mold; and
d) baking the compacted mixture at a temperature of less than 1,500°C.

6. A fabrication method according to claim 5, **characterized in that** the stabilizer comprises at least one element belonging to the group formed by rare earth oxides, tantalum oxide, and niobium oxide.

7. A fabrication method according to claim 5 or claim 6, **characterized in that** step a) includes preparing at least one second mixture having a second composition from a binder and powders comprising zirconia and at least one zirconia stabilizer, said zirconia being formed by more than 90% of a monoclinic phase, and **in that** step b) comprises introducing the first mixture and the second mixture in succession, thereby obtaining a target having composition that varies along its height.

8. A fabrication method according to any one of clams 5 to 7, **characterized in that** said ceramic powders present a mean particle diameter lying in the range 5 µm to 30 µm.

9. A fabrication method according to any one of claims 5 to 7, **characterized in that** said ceramic powders present a mean particle diameter of less than 5 µm, and **in that** step a) includes a substep of calcining the powder prior to incorporating the binder.

## Patentansprüche

1. Stabförmiges Verbundtarget, das aus Keramikpulvern besteht und dazu bestimmt ist, unter Elektronenstrahl verdampft zu werden, enthaltend Zirkonoxid sowie wenigstens einen Zirkonoxid-Stabilisator, **dadurch gekennzeichnet, daß** der Zirkonoxid-Stabilisator mit einem Molgehalt zwischen 2 und 30 % enthalten ist, daß das Zirkonoxid nach dem Sintern zu mehr als 90 % von einer monoklinen Phase gebildet ist, daß es einen mittleren Porendurchmesser d₅₀ von weniger als 2 µm und eine Porosität von 30 bis 50 % aufweist.

2. Target nach Anspruch 1, **dadurch gekennzeichnet, daß** der Stabilisator wenigstens ein Element umfaßt, das zu der Gruppe bestehend aus Seltenerdoxiden, Tantaloxid und Nioboxid gehört.

3. Target nach einem der vorhergehenden Ansprüche, **dadurch gekennzeichnet, daß** es eine Dichte von unter 3,9 aufweist.

4. Target nach einem der vorhergehenden Ansprüche, **dadurch gekennzeichnet, daß** es eine höhenveränderliche Zusammensetzung aufweist.

5. Verfahren zur Herstellung eines stabförmigen Verbundtargets nach einem der vorhergehenden Ansprüche, das aus Keramikpulvern besteht und dazu bestimmt ist, unter Elektronenstrahl verdampft zu werden, **dadurch gekennzeichnet, daß** es die folgenden Schritte umfaßt:
a) Zubereiten wenigstens einer ersten Mischung mit einer ersten Zusammensetzung, aus einem Bindemittel und Pulvern, die Zirkonoxid sowie wenigstens einen Zirkonoxid-Stabilisator enthalten, wobei das Zirkonoxid zu mehr als 90 % von einer monoklinen Phase gebildet ist,
b) Einbringen der Mischung in eine Form,
c) Verdichten der Mischung in der Form,
d) Härten der verdichteten Mischung bei einer Temperatur vcn unter 1500 °C.

6. Herstellungsverfahren nach Anspruch 5, **dadurch gekennzeichnet, daß** der Stabilisator wenigstens ein Element umfaßt, das zu der Gruppe bestehend aus Seltenerdoxiden, Tantaloxid und Nioboxid gehört.

7. Herstellungsverfahren nach Anspruch 5 oder 6, **dadurch gekennzeichnet, daß** Schritt a) die Zubereitung wenigstens einer zweiten Mischung mit einer zweiten Zusammensetzung, aus einem Bindemittel und Pulvern, die Zirkonoxid sowie wenigstens einen Zirkonoxid-Stabilisator enthalten, umfaßt, wobei das Zirkonoxid zu mehr als 90 % von einer monoklinen Phase gebildet ist, und daß Schritt b) das nacheinander erfolgende Einbringen der ersten Mischung und der zweiten Mischung umfaßt, wodurch ein Target mit einer höhenveränderlichen Zusammensetzung erhalten wird.

8. Herstellungsverfahren nach einem der Ansprüche 5 bis 7, **dadurch gekennzeichnet, daß** die Keramikpulver einen mittleren Teilchendurchmesser zwischen 5 und 30 µm aufweisen.

9. Herstellungsverfahren nach einem der Ansprüche 5 bis 7, **dadurch gekennzeichnet, daß** die Keramikpulver einen mittleren Teilchendurchmesser von unter 5 µm aufweisen und daß Schritt a) einen Teilschritt zum Brennen des Pulvers vor Beimischen des Bindemittels umfaßt.
